# EUROPEAN PATENT SPECIFICATION

(11) **EP 1 353 326 B1**
(45) Date of publication and mention of the grant of the patent: **13.09.2006**
(21) Application number: 03251223.8
(22) Date of filing: 28.02.2003
(51) Int. Cl.: G11B 7/00, G11B 27/19, G11B 27/24, G11B 20/14, G11B 7/007

(54) **Apparatus for detecting and correcting wobble error and phase locked loop circuit using the same**
Anordnung zum Ausmachen und Korrigieren eines Wobblefehlers und damit ausgestatteter Phasenverriegelungskreis
Appareil de détection et de correction d'une erreur de wobulation et circuit de verrouillage de phase utilisant ce dernier

(30) Priority: 11.04.2002 KR 2002019721
(43) Date of publication of application: 15.10.2003
(73) Proprietor: SAMSUNG ELECTRONICS CO., LTD., Suwon-City, Kyungki-do (KR)
(72) Inventor: Park, Hyun-soo, Seodaemun-gu, Seoul (KR); Shim, Jae-seong, Seoul (KR)
(74) Representative: Robinson, Ian Michael

(56) References cited:
- EP-A- 0 967 612
- EP-A- 1 225 582
- US-A1- 2002 018 414

## Description

The present invention relates to detecting a wobble signal on an optical recording medium and using the wobble signal to correct an error thereof, and more particularly, to an apparatus for detecting an error in a wobble signal on an optical recording medium and correcting the wobble error, and a phase locked loop (PLL) circuit using the apparatus.

In general, when reproducing data on an optical recording medium such as CD and DVD-ROM, a system clock is generated from a wobble signal on the optical recording medium, using a phase locked loop (PLL) circuit.

Tracks of concentric circles are formed on a surface of a recordable optical recording medium such as CD-R, CD-RW, and DVD-RAM, thereby enabling writing of data to the surface thereof. To record data at a desired position of the surface of such a disc, it is required to follow a target track of the disc on which data is to be recorded and record the data on the track. To accomplish following the target track, processes for detecting the position of a pickup on the disc are needed, and a wobble signal, which is a single frequency signal, is formed on a surface of a disc to be used during the detecting processes.

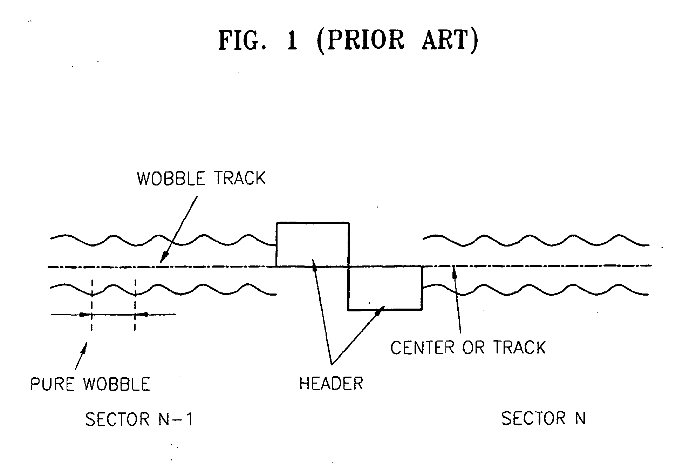

Figure 1 is a partial diagram of tracks of an optical recording medium, i.e., a DVD-RAM. Referring to Figure 1, wobble signals and a header information signal are recorded along tracks. A header, in which information regarding the position of the disc is recorded according to predetermined rules, is interleaved with the wobble signals. The position or address of the disc can be detected using the information recorded in the header.

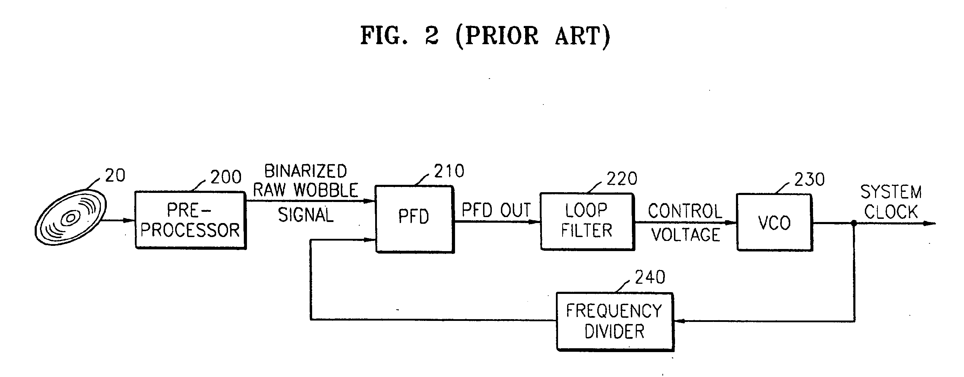

Figure 2 is a block diagram of a conventional system clock generator using a wobble signal on an optical recording medium as shown in Figure 1. The system clock generator of Figure 2 includes a preprocessor 200, a phase frequency detector (PFD) 210, a loop filter 220, a voltage controlled oscillator (VCO) 230, and a frequency divider 240.

The preprocessor 200 reads a wobble signal from an optical recording medium 20 using an optical pickup, binarizes the wobble signal, and outputs the binarized wobble signal as a raw wobble signal rwb.

The PFD 210 compares the binarized wobble signal output from the preprocessor 200 with a phase locked wobble signal and outputs a difference therebetween.

The loop filter 220 filters an output of the PFD 210 to output a stable control voltage signal.

The VCO 230 generates an oscillation signal of frequency that is proportional to that of the voltage signal output from the loop filter 220 and outputs the oscillation signal. The oscillation signal acts as a system clock signal.

The frequency divider 240 divides a frequency of the clock output from the VCO 230 to a predetermined frequency of the clock and outputs the result as a phase locked wobble signal pwb.

The system clock generator of Figure 2 is a representative example of a PLL circuit that is required in performing writing and reading operations using a wobble signal on an optical recording medium, in synchronization with a binarized wobble signal rwb.

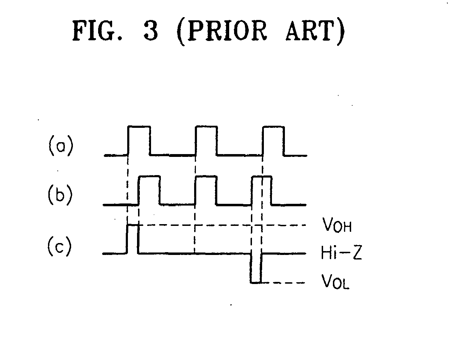

Figure 3 is a timing diagram of signals for explaining the operation of the PFD 210 of Figure 2. Referring to Figure 3, (a) and (b) denote a raw wobble signal rwb and a phase locked wobble signal pwb input to the PFD 210, respectively, and (c) denotes a signal, output from the PFD 210, which is a voltage signal representing a difference of phase between the signals rwb and pwb.

As shown in Figure 3, the PFD 210 detects the rising edges of the signals rwb and pwb and outputs a phase difference between these signals as a voltage signal that changes at three levels: a level of high voltage *V*_{*OH*}, a level of low voltage *V*_{*OL*}, and a level of high impedance *Hi-Z*. In most cases, the PFD 210 operates normally but it may mistakenly operate when noise, such as a glitch, is input to the PFD 210.

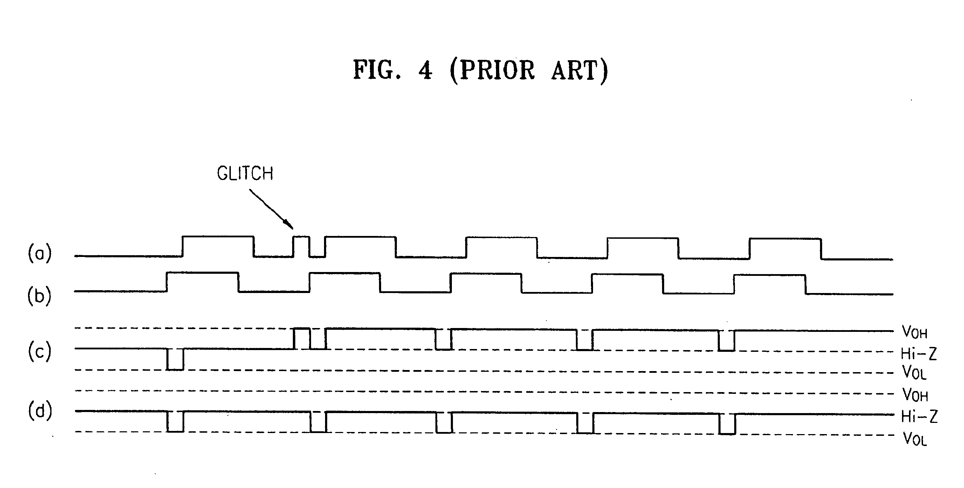

Figure 4 is a timing diagram of signals for explaining malfunction of the PFD 210 of Figure 2. Referring to Figure 4, (a) and (b) denote an input raw wobble signal rwb and an input phase locked wobble signal pwb, respectively. The signal rwb may include a glitch signal generated due to physical defects of an optical recording medium. (c) denotes an actual voltage signal output from the PFD 210, which is a measure of the phase difference between the signals rwb and pwb. (d) denotes a desired signal output from the PFD 210 not in consideration of the glitch in the signal rwb.

When the PFD 210 malfunctions to output the signal (c) due to the glitch contained in the signal rwb, it is impossible to stop the PFD 210 from malfunctioning. The malfunction of the PFD 210 may results in the generation of an abnormal system clock and may make it difficult to perform the writing and reading operations on an optical recording medium.

US 2002/0018 414 and EP 0 967 612 A reflect prior art concerned with information taken from a wobble signal.

An aim of the present invention is to provide a phase locked loop circuit for an optical recording or reproducing apparatus, which reliably generates a system clock and avoids malfunctioning due to errors such as glitches in a raw wobble signal rwb. An aim of at least preferred embodiments of the present invention is to provide an apparatus that functions reliably even when the raw wobble signal rwb contains errors.

According to the present invention there is provided an apparatus and method as set forth in the appended claims. Preferred features of the invention will be apparent from the dependent claims, and the description which follows.

The present invention provides an apparatus for detecting and correcting a wobble error using a detection window during the detecting of wobble on an optical recording medium.

The present invention also provides a phase locked circuit that is capable of stably generating a system clock using a wobble corrected through such an apparatus.

According to one aspect of the present invention there is provided an apparatus for detecting and correcting an error in a wobble signal, including a window generator generating a window signal using a phase locked wobble signal (pwb), the pwb being generated in synchronization with a raw wobble signal (rwb) and the signal rwb being obtained by binarizing the wobble signal read from an optical recording medium, and a control operation unit correcting an error in the signal rwb and outputting the corrected rwb when the error in the signal rwb is detected in a window.

It is preferable that the window generator generates a window pulse with a predetermined width at the right and left sides of a rising edge of the signal pwb.

It is preferable that the window generator comprises a right window signal generator generating a window pulse with a predetermined width at the right side of the rising edge of the signal pwb; a left window signal generator generating a pulse signal of a predetermined width at the left side of the rising edge of the signal pwb; and a window signal combiner combining the right window pulse and the left window pulse and outputting the combination result.

It is preferable that the right window signal generator comprises a first comparator comparing a first window threshold value with a count value obtained by counting the PLL wobble signal in units of system clocks, outputting level '1' when the count value is smaller than or the same as the first window threshold value, and outputting level '0' otherwise; and a first AND operation unit performing an AND operation on an output of the first comparator and the pwb and outputting the operation result.

It is preferable that the left window signal generator comprises a second comparator comparing a second window threshold value with a count value obtained by counting the pwb in units of system clocks, outputting level '1' when the count value is larger than or the same as the second window threshold value, and outputting level '0' otherwise; and a second AND operation unit performing an AND operation on an output of the second comparator and the PLL wobble signal and outputting the operation unit.

It is preferable that the first window threshold value, the second window threshold value, or the count value of a cycle of the signal pwb can be arbitrarily set or changed using a controller.

It is preferable that the control operation unit comprises a delay unit delaying the rwb and the pwb for a predetermined time until the error in the raw wobble signal is detected and corrected; a lock signal generator checking if a PLL operates normally; a selection signal generator receiving a signal indicating whether the PLL is locked from the lock signal generator, checking the presence of a rising edge of the raw wobble signal in the window based on the signal, and generating a control value for correcting the error; and a wobble signal selector selecting one of the input rwb and the pwb in response to the control value output from the selection signal generator.

It is preferable that the control operation unit further comprises a deglitch circuit removing glitch from the rwb and outputting the deglitched rwb to the delay unit, the rwb being obtained by binarizing a wobble signal read from an optical recording medium.

It is preferable that the lock signal generator outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

It is preferable that the selection signal generator outputs a first control value for selecting the rwb when a signal, which indicates the unlocking of the PLL, is output from the lock signal generator, and the selection signal generator checks if a window appears, the selection signal generator outputs a second control value for selecting the pwb out of the window timing, outputs the first control value in the window timing when the rising edge of the raw wobble signal is detected, and outputs the second control value in the window timing when the rising edge of the raw wobble signal is not detected.

It is preferable that the wobble signal selector outputs the rwb when the first control value is output from the selection signal generator, and outputs the pwb when the second control value is output from the selection signal.

According to another aspect of the present invention, there is provided a phase locked loop (PLL) circuit that generates system clocks using a wobble signal output from an optical recording medium, the PLL circuit comprising a wobble signal correcting unit checking whether a raw wobble signal rwb is phase locked, correcting the signal rwb, and inputting the corrected signal rwb to a PLL, the signal rwb being from an optical recording medium and binarized.

It is preferable that the wobble signal correcting unit comprises a window generator generating a detection window using a phase locked wobble signal pwb, the signal pwb obtained by phase locking the signal rwb using the PLL; and a control operation unit correcting and outputting an error in the signal rwb when the error is detected in a window.

It is preferable that the window generator generates a pulse signal of a predetermined width at the right and left sides of a rising edge of the signal pwb.

It is preferable that the window generator comprises a right window signal generator generating a pulse signal of a predetermined width at the right side of the rising edge of the signal pwb; a left window signal generator generating a pulse signal of a predetermined width at the left side of the rising edge of the signal pwb; and a window signal combiner combining the right pulse signal and the left pulse signal and outputting the combination result.

It is preferable that the right window signal generator comprises a first comparator comparing a first window threshold value with a count value, outputting level '1' when the count value is smaller than or the same as the first window threshold value, and outputting level '0' otherwise, the count value obtained by counting the signal pwb in units of system clocks; and a first AND operation unit performing an AND operation on an output of the first comparator and the signal pwb and outputting the operation result.

It is preferable that the left window signal generator comprises a second comparator comparing a second window threshold value with a count value, outputting level '1' when the count value is larger than or the same as the second window threshold value, and outputting level '0' otherwise, the count value obtained by counting the signal pwb in units of system clocks; and a second AND operation unit performing an AND operation on an output of the second comparator and the signal pwb and outputting the operation result.

It is preferable that the first window threshold value, the second threshold value, or the count value of a cycle of the signal pwb may be arbitrarily set or changed using a controller such as a microcomputer.

It is preferable that the control operation unit comprises a delay unit delaying the rwb and pwb for a predetermined time until the error in the signal rwb is detected and corrected; a lock signal generator checking if the PLL operates normally; a selection signal generator receiving a signal indicating whether the PLL is locked from the lock signal generator, checking the presence of a rising edge of the raw wobble signal in the window based on the signal, and generating a control value for correcting the error; and a wobble signal selector selecting one of the input rwb and the pwb in response to the control value output from the selection signal generator.

It is preferable that the control operation unit further comprises a deglitch circuit removing glitch from the rwb and outputting the deglitched rwb to the delay unit, the rwb being obtained by binarizing a wobble signal read from an optical recording medium.

It is preferable that the lock signal generator outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

It is preferable that the selection signal generator outputs a first control value for selecting the rwb when a signal, which indicates the unlocking of the PLL, is output from the lock signal generator, and the selection signal generator checks if a window appears, the selection signal generator outputs a second control value for selecting the pwb out of the window timing, outputs the first control value in the window timing when the rising edge of the raw wobble signal is detected, and outputs the second control value in the window timing when the rising edge of the raw wobble signal is not detected.

It is preferable that the wobble signal selector outputs the signal rwb in response to the first control value generated from the selection signal generator, and outputs the signal pwb in response to the second control value generated from the selection signal generator.

According to still another aspect of the present invention, there is provided a phase locked loop (PLL) circuit that generates system clocks using a wobble signal output from an optical recording medium, comprising: a preprocessor reading a wobble signal output from an optical recording medium, binarizing the wobble signal, and outputting the binarized wobble signal as a raw wobble signal rwb; a wobble error detecting and correcting unit detecting an error in the signal rwb and outputting a phase locked signal pwb instead of the signal rwb when the error in the signal rwb is detected, the signal pwb being in phase with the signal rwb; a phase comparator comparing the phase of the corrected signal rwb output from the wobble error detecting and correcting unit with that of the signal pwb, and outputting a voltage corresponding to the difference between the corrected rwb and the pwb; a voltage-controlled oscillator converting a voltage signal output from the phase comparator into a system clock signal of predetermined frequency and outputting the system clock signal; and a frequency divider dividing the frequency of system clock signal to follow the signal rwb and outputting the result as the signal pwb.

It is preferable that the wobble error detecting and correcting unit comprises: a window generator generating a window using the signal pwb obtained by phase locking the signal rwb through a PLL; and a control operation unit correcting the error in the signal rwb and outputting the corrected signal rwb when the error in the signal rwb is detected in a window.

It is preferable that the window generator generates a pulse signal of predetermined width at the right and left sides of the rising edge of the signal pwb.

It is preferable that the window generator comprises a right window signal generator generating a pulse signal of predetermined with at the right side of the rising edge of the signal pwb; a left window signal generator generating a pulse signal of predetermined width at the left side of the rising edge of the signal pwb; and a window signal combiner combining the pulse signals at the right and left sides of the rising edge and outputting the combination result.

It is preferable that the right window signal generator comprises a first comparator comparing a first window threshold value with a count value, outputting level '1' when the count value is smaller than or the same as the first window threshold value, and outputting level '0' otherwise, the count value obtained by counting the signal pwb in units of system clocks; and a first AND operation unit performing an AND operation on an output of the first comparator and the signal pwb and outputting the operation result.

It is preferable that the left window signal generator comprises a second comparator comparing a second window threshold value with a count value, outputting level '1' when the count value is larger than or the same as the second window threshold value, and outputting level '0' otherwise, the count value obtained by counting the signal pwb in units of system clocks; and a second AND operation unit performing an AND operation on an output of the second comparator and the signal pwb and outputting the operation result.

The first window threshold value, the second window threshold value, or the count value of the cycle of the signal pwb may be arbitrarily set or changed using a controller such as a microcomputer.

It is preferable that the control operation unit comprises a delay unit delaying the rwb and the pwb for a predetermined time until the error in the raw wobble signal is detected and corrected; a lock signal generator checking if a PLL operates normally; a selection signal generator receiving a signal indicating whether the PLL is locked from the lock signal generator, checking the presence of a rising edge of the raw wobble signal in the window based on the signal, and generating a control value for correcting the error; and a wobble signal selector selecting one of the input rwb and the pwb in response to the control value output from the selection signal generator.

It is preferable that the control operation unit further comprises a deglitch circuit removing glitch from the rwb and outputting the deglitched rwb to the delay unit, the rwb being obtained by binarizing a wobble signal read from an optical recording medium.

It is preferable that the lock signal generator outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

It is preferable that the selection signal generator outputs a first control value for selecting the rwb when a signal, which indicates the unlocking of the PLL, is output from the lock signal generator, and the selection signal generator checks if a window appears, the selection signal generator outputs a second control value for selecting the pwb out of the window timing, outputs the first control value in the window timing when the rising edge of the raw wobble signal is detected, and outputs the second control value in the window timing when the rising edge of the raw wobble signal is not detected.

It is preferable that the wobble signal selector outputs the signal rwb in response to the first control value output from the selection signal generator, and outputs the signal pwb in response to the second control value output from the selection signal generator.

For a better understanding of the invention, and to show how embodiments of the same may be carried into effect, reference will now be made, by way of example, to the accompanying diagrammatic drawings in which:
Figure 1 is a partial diagram of a DVD-RAM which is an optical recording medium;
Figure 2 is a block diagram of an example of a general system clock generator using a wobble signal on an optical recording medium as shown in Figure 1;
Figure 3 is a timing diagram of signals for explaining the operation of a phase frequency detector of Figure 2;
Figure 4 is a timing diagram of signals for explaining malfunctions of the phase frequency detector of Figure 2;
Figure 5 is a block diagram of a system clock generator having a function of preventing a fault in a wobble signal, according to an embodiment of the present invention;
Figure 6A is a circuit diagram of a frequency divider of Figure 5;
Figure 6B is a circuit diagram of a window generator of Figure 5;
Figure 7 illustrates a waveform of a phase locked wobble signal pwb and a window signal that is generated from the signal pwb using the window generator of Figure 6B;
Figure 8 is a block diagram of a control operation unit that detects an error in a raw wobble signal rwb of Figure 5;
Figure 9 is a block diagram of a deglitch circuit of Figure 8 according to an embodiment of the present invention;
Figure 10 is a block diagram of a delay unit of Figure 8 according to an embodiment of the present invention;
Figure 11 is a flowchart illustrating the operation of a lock signal generator of Figure 8;
Figure 12 is a flowchart illustrating the operation of a selection signal generator of Figure 8; and
Figure 13 is a timing diagram of signals for explaining a process for correcting a raw wobble signal rwb according to the present invention.

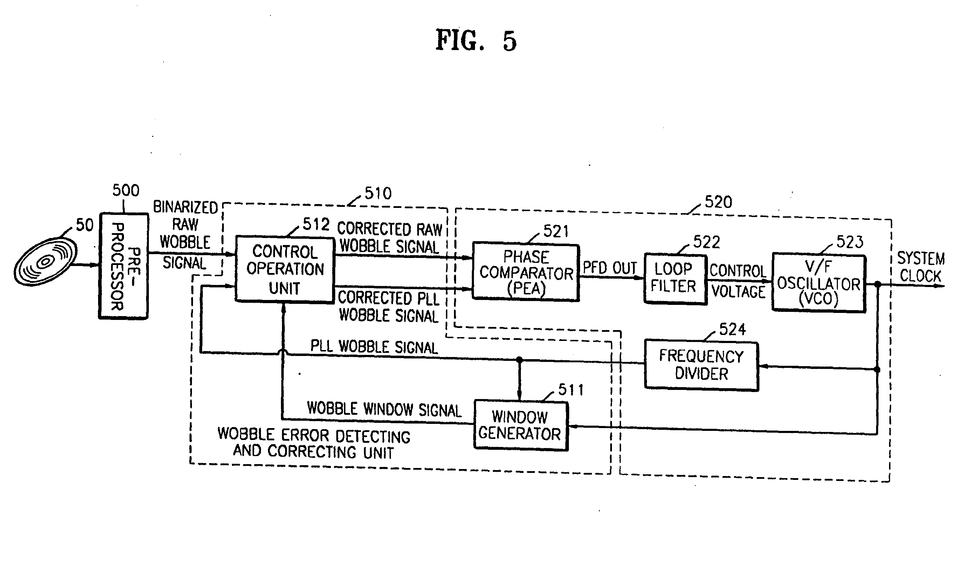

Figure 5 is a system clock generator having a function of preventing a fault of wobble, according to an embodiment of the present invention. Referring to Figure 5, the system clock generator includes a preprocessor 500, a wobble error detecting and correcting unit 510, and a phase locked circuit 520.

The preprocessor 500 reads a wobble signal recorded on an optical recording medium 50, such as a DVD, and binarizes the read wobble signal. A binarized wobble signal will be referred to as a 'raw wobble signal rwb' in this disclosure. The signal rwb may contain an error generated due to physical defects of an optical recording medium or channel interference during a reading operation of the optical recording medium.

The wobble error detecting and correcting unit 510 detects an error in the signal rwb and outputs a phase locked wobble signal pwb, i.e., a phase locked signal, that is in phase with the signal rwb and does not contain an error. An error in the signal rwb is detected by a window generator 511. The window generator 511 generates window signals of predetermined widths at the right and left sides of the signal pwb made from the signal rwb, in synchronization with the rising edge of the signal pwb. A control operation unit 512 detects an error in the signal rwb and outputs an error correction signal, using the window signal. In detail, the control operation unit 512 checks if an error is contained in the signal rwb using the window signal, and corrects the signal rwb at a corresponding instant of time of which an error is detected and outputs the corrected signal. The signal rwb may be corrected using various ways. However, the signal rwb containing an error is corrected by outputting the signal pwb instead of the signal rwb, according to an embodiment of the present invention. This method will now be described in detail.

The PLL circuit 520 according to the present invention has the same circuit structure as a general PLL circuit. The PLL circuit 520 includes a phase comparator 521 which compares the phase of the corrected signal rwb with that of the signal pwb output from the wobble error detecting and correcting unit 510 and outputs a voltage signal corresponding to a phase difference between these signals. The output voltage signal passes through a loop filter 522 to be stabilized. Also, the stabilized voltage signal is input to a voltage controlled oscillator (VCO) 523 and output as a system clock signal with a predetermined frequency. A frequency divider 524 divides the system clock signal to follow the signal rwb and outputs the result as the signal pwb. In conclusion, the system clock and the signal pwb are generated from the signal rwb from which an error, such as a glitch, is removed, and thus, the system clock and the signal pwb are stably output. The system clock and the signal pwb output from the PLL circuit 520 are used to generate the window signal and the corrected signal rwb in the wobble error detecting and correcting unit 510.

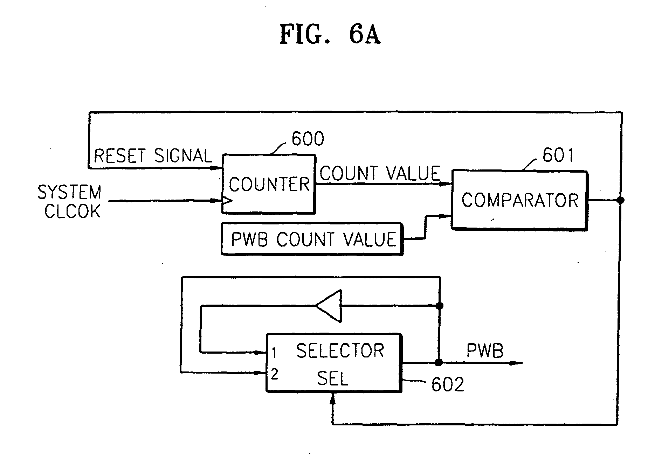

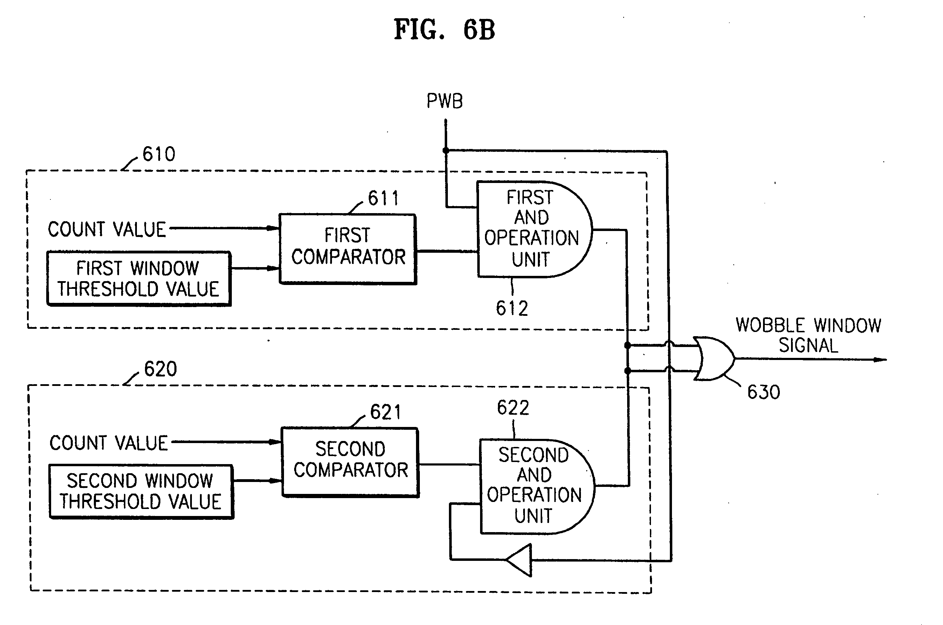

Figures 6A and 6B illustrate the frequency divider 524 and the window generator 511 shown in Figure 5, respectively.

Referring to Figure 6A, the frequency divider 524 includes a counter 600, a comparator 601, and a selector 602. The counter 600 performs counting operations whenever a system clock is input to the counter 600, and is reset in response to a reset signal.

The comparator 601 compares a count value output from the counter 600 with a predetermined count value of a desirable phase locked wobble signal pwb. Then, the comparator 601 outputs a first signal when the counter value is the same as the predetermined count value, and outputs a second signal when these values are different from each other. In the case of a DVD, 186 system clocks may be included within a preferable wobble period. In this case, the preferable count value of the signal pwb is set to be 92 because there are 93 clocks (counting begins with 0). When an output of the counter 600 is 92, the comparator 601 outputs the first signal corresponding to the reset signal. The first signal is input to the counter 600 and resets the counter value to be 0.

In the selector 602, a signal output from the selector 602 is inverted and set to be a first input, and the signal output from the selector 602 is set to be a second input. In response to a selection signal *sel,* one of the first and second inputs is selected. That is, the selector 602 selects and outputs the first input which is inversion of a previous output signal if an output of the comparator 601 is the reset signal, i.e., the first signal. Otherwise, the selector 602 selects and outputs the second input that is a present input. In the case of a DVD, the level of a signal is inverted whenever 93 clocks are counted. Thus, during the counting of 186 clocks, a desirable phase locked wobble signal pwb having two levels of signal can be generated.

The window generator 511 of Figure 6B includes a right window signal generator 610, a left window signal generator 620, and a window signal combiner 630.

The right window signal generator 610 includes a first comparator 611 and a first AND operation unit 612. An output of the counter 600 of Figure 6A and a predetermined first window threshold value, which is predetermined in consideration of the width of a window, are input to the first comparator 611. An output of the first comparator 611 is 1 only when the output of the counter 600 is smaller than or the same as the first window threshold value. Otherwise, the output of the first comparator 611 is 0. For instance, the output of the first comparator 611 is level '1' when the first window threshold value is 4 and the outputs of the counter 600 are 0, 1, 2, 3, and 4. Otherwise, the output of the first comparator 611 is 0. The first AND operation unit 612 performs an AND operation on the output of the first comparator 611 and the signal pwb of Figure 6A and outputs the result. The first AND operation unit 612 permits generation of a window signal around a rising edge of a phase locked wobble signal pwb but does not permit generation of the window signal around a falling edge of the signal pwb.

The left window signal generator 620 includes a second comparator 621 and a second AND operation unit 622. An output of the counter 600 and a predetermined second threshold value, which is predetermined in consideration of the width of a window, are input to the second comparator 621. When the output of the counter 600 is larger than or the same as the second window threshold value, the output of the second comparator 621 is level '1'. Otherwise, the output of the second comparator 621 is level '0'. For instance, the output of the second comparator 621 is level '1' when the second window threshold value is 90 and the outputs of the counter 600 are 90, 91, and 92. Otherwise, the output of the second comparator 621 is level '0'. The second AND operation unit 622 performs an AND operation on the output of the second comparator 621 and an inversion value of the signal pwb of Figure 6B and outputs the result. The second AND operation unit 622 permits generation of the window signal around a rising edge of the signal pwb but does not permit generation of the window signal around a falling edge of the signal pwb.

The window signal combiner 630 combines an output of the right window signal generator 610 and an output of the left window signal generator 620, and outputs the combination result. The window signal combiner 630 may be an OR operation unit. That is, an OR operation is performed on a signal output from the right window signal generator 610 and a signal output from the left window signal generator 620 and as a result, the right window signal and left window signal are combined with each other.

The count value for a period of the signal pwb, as well as first and second window threshold values, may be arbitrarily set or changed using a controller such as a MICOM (not shown). According to the present invention, a window signal of a predetermined width is formed around a rising edge of the signal pwb in order to use the window signal when detecting an error in a wobble signal. To generate the window signal, count values can be appropriately set at the right and left sides of a rising edge of the signal pwb, which is counted from 0, in consideration of a predetermined width of the window signal. The set count values are the first and second window threshold values.

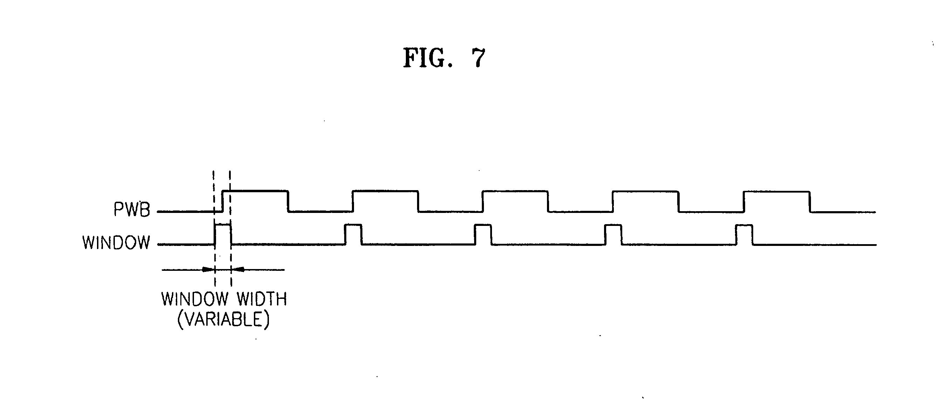

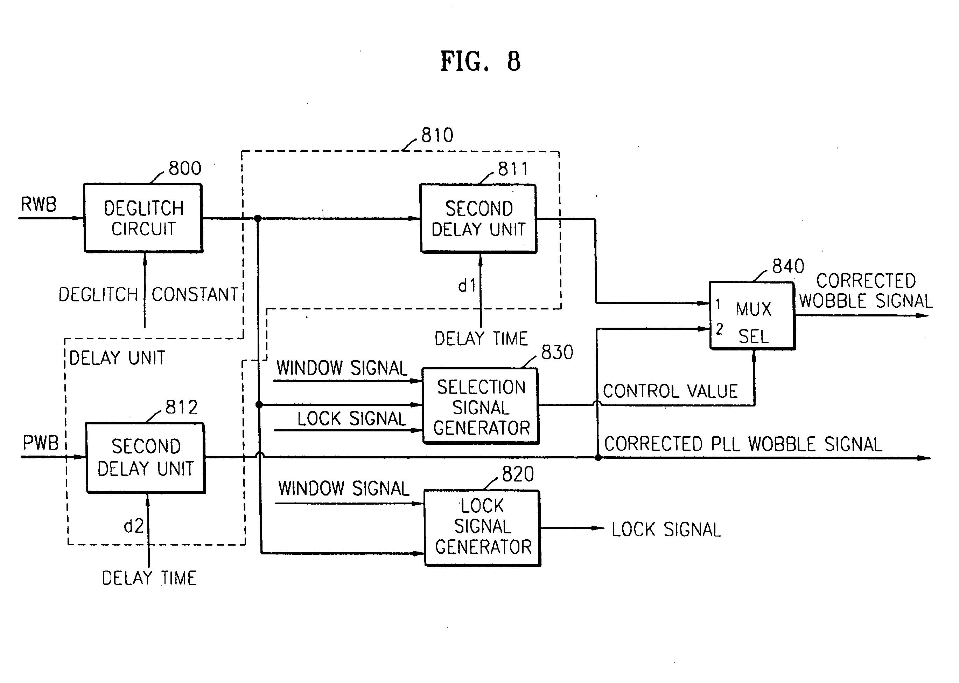

Figure 7 illustrates a waveform of the window signal generated by the window generator 511 shown in Figure 6B. Figure 8 is a block diagram of the control operation unit 512 of Figure 5 that detects and corrects an error in a raw wobble signal rwb.

Referring to Figure 8, the control operation unit 512 includes a delay unit 810, a lock signal generator 820, a selection signal generator 830, and a wobble signal selector 840.

The signal rwb, which is obtained by binarizing a wobble signal read from an optical recording medium, is input to a deglitch circuit 800 to remove noise contained in the signal rwb. The deglitch circuit 800 is capable of removing a pulse signal of a very short period, which is contained in the signal rwb, but inclusion of the deglitch circuit 800 into the control operation unit 512 is optional. A glitch removal constant of the deglitch circuit 800 may be arbitrarily set or changed using a controller such as a MICOM (not shown).

The delay unit 810 delays the signal rwb and a phase locked wobble signal pwb for a predetermined time. For the delay of these signals, a first delay circuit 811 and a second delay circuit 812 are used. The signals rwb and pwb must be delayed for the predetermined time, because an error contained in the signal rwb is checked after input of the signal rwb which may contain the error (the detection of the error in the signal rwb will be later explained) and the signal rwb may be processed to output without being corrected before the detection of the error. That is, the input signal rwb are delayed together with the signal pwb until the detection of an error in the signal rwb, so as to remove the detected error using the input signal pwb after the error is detected.

The lock signal generator 820 checks if a phase locked loop (PLL) operates normally. If the PLL operates normally, a rising edge of the signal rwb must be detected from a window signal generated by the window generator 511. When rising edges of the signal rwb are continuously detected from the window signal predetermined times, the lock signal generator 820 outputs a signal indicating the locking of the PLL. Otherwise, the lock signal generator 820 outputs a signal indicating the unlocking of the PLL.

The selection signal generator 830 receives a lock signal, which indicates whether the PLL is locked, from the lock signal generator 820, checks whether a rising edge of the signal rwb is detected from the window signal so as to determine whether an error is contained in the signal rwb, and generates a control value for correcting the error in the signal rwb. In other words, the selection signal generator 830 generates a first control value for selecting the signal rwb when the PLL is not locked, and generates a second control value for selecting the signal pwb in sections, except for sections of the window signal, when the PLL is locked. While the PLL is locked, the selection signal generator 830 outputs the first control value for selecting the signal rwb when a rising edge of the signal rwb is detected in the window signal, and outputs the second control value for selecting the signal pwb when the rising edge is not detected in the window signal. Meanwhile, the selection signal generator 830 outputs the first control value since the signal rwb has to be input to the PLL circuit 520 until the signals rwb and pwb are almost in phase if the PLL is not locked. If the PLL is locked, it can be understood that the signals rwb and pwb are almost in phase, and thus, when an error is detected from the signal rwb, the stable signal pwb, instead of the signal rwb, can be output. Accordingly, an error in the signal rwb is detected using the window signal, and the first or second control value for selecting the signal rwb or pwb is generated.

The wobble signal generator 840 selects and outputs one of the signals rwb and pwb in response to the first or second control value output from the selection signal generator 830. The output of the signal rwb corresponds to a case where the stable signal pwb is not yet output since the PLL is not locked, or an error is not detected from the signal rwb after the locking of the signal rwb. The output of the signal pwb corresponds to a case where an error is detected from the signal rwb after the locking of the signal rwb.

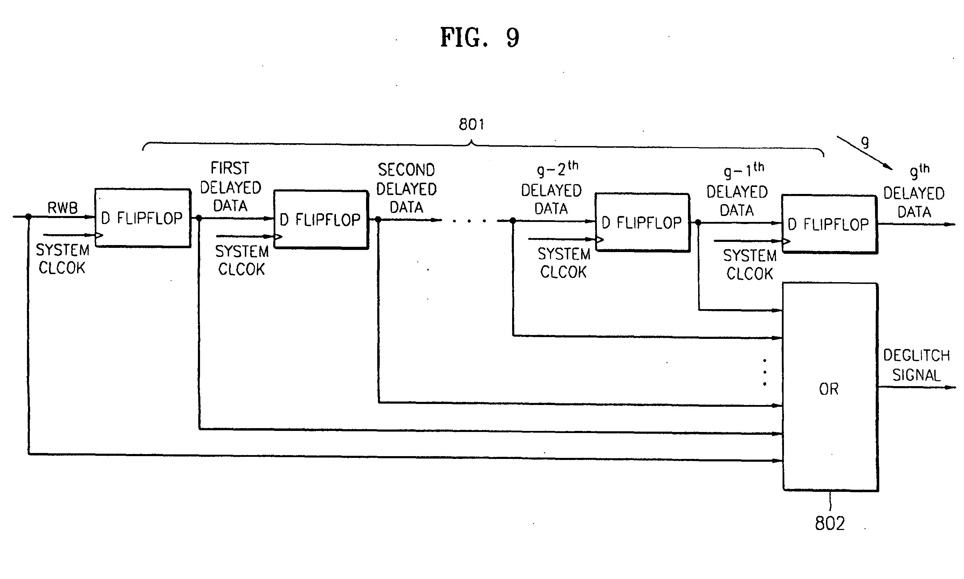

Figure 9 is a block diagram of the deglitch circuit 800 of Figure 8, according to an embodiment of the present invention. The deglitch circuit of Figure 9 includes predetermined numbers of delay circuits 801 and an OR circuit 802. The deglitch circuit of Figure 9 delays outputs of an input raw wobble signal rwb containing glitch at predetermined intervals of time, combines signals output from each of the delay circuits 801, and outputs the combination result, so as to remove the glitch. The glitch circuit delays the output of the signal rwb in units of system clocks. A glitch removal constant (delay time: *g*) may be arbitrarily set or changed using a controller such as a microcomputer (not shown).

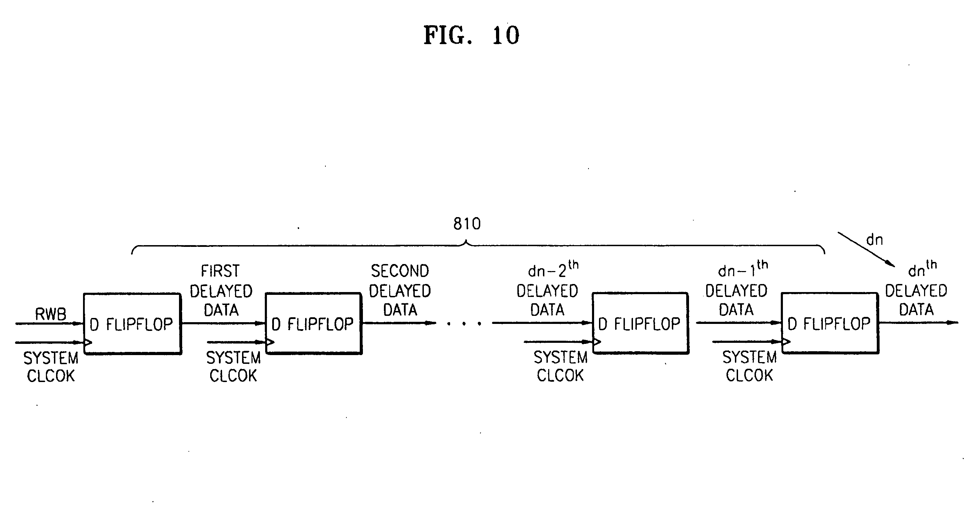

Figure 10 is a block diagram illustrating the structure of the delay unit 810 of Figure 8, according to an embodiment of the present invention. Referring to Figure 10, the delay unit 810 serially connects delay circuits such as D flip-flops circuits and delays an input raw wobble signal rwb, whenever a system clock is input. A delay constant, i.e., the number of delay circuits, may be arbitrarily set or changed using a controller such as a microcomputer (not shown).

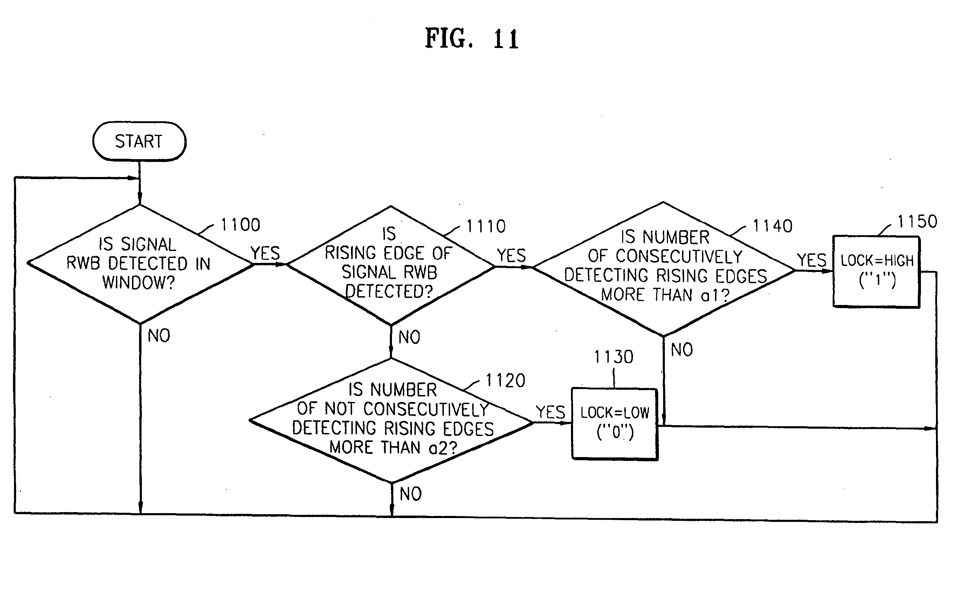

Figure 11 is a flowchart illustrating the operation of the lock signal generator 810 of Figure 8. Referring to Figure 11, whether the timing is for a window section is checked from the window signal in step 1100. If the signal rwb is detected within the window section, whether a rising edge of the signal rwb is detected in the window section is checked in step 1110. If the rising edge of the signal rwb is not detected in the window section, whether the number of not consecutively detecting rising edges is more than a2 is checked in step 1120. If the number is more than a2, a signal indicating the PLL unlocking is output, e.g., lock = low, in step 1130.

If the rising edges of the signal rwb are detected in the window section, whether the number of consecutively detecting rising edges is more than a1 is checked in step 1140. In this case, a signal indicating the PLL locking of the signal rwb is output in step 1150.

The PLL locking means that the signal rwb and a phase locked wobble signal pwb become to be in phase, in which whether the signal pwb is in synchronization with the signal rwb using a window signal generated from a rising edge of the signal pwb.

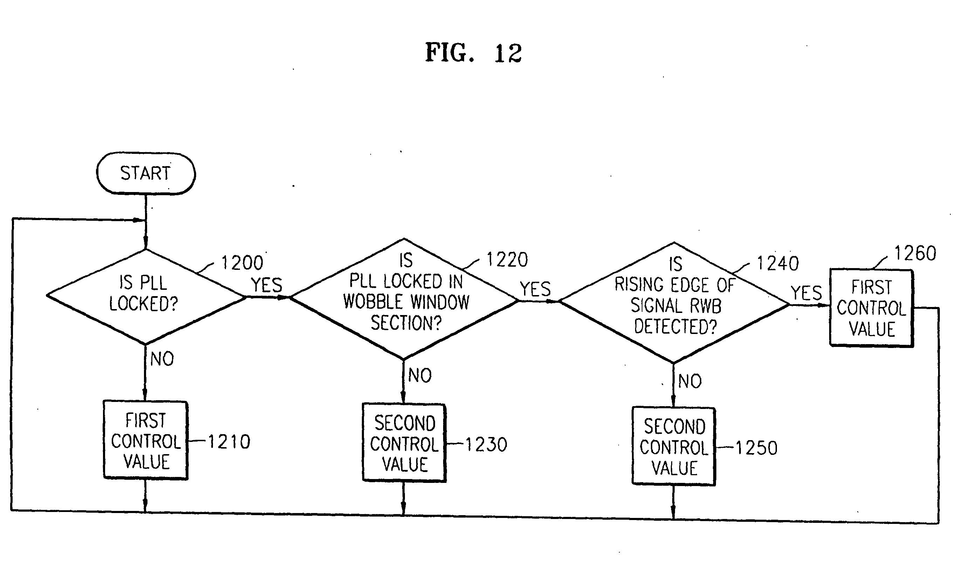

Figure 12 is a flowchart illustrating the operation of the selection signal generator 80 of Figure 8, according to an embodiment of the present invention. First, whether a PLL is locked or not is checked in step 1200. If the PLL is not locked, a first control value is output to select a raw wobble signal rwb until the signal rwb and a phase locked wobble signal pwb are in phase, in step 1210.

If the PLL is locked, whether the PLL is locked within a wobble window section is checked in step 1220. If the PLL is not locked in the wobble window section, a second control value is output to select the signal pwb in step 1230. If the PLL is locked in the wobble window section, whether a rising edge of the signal rwb is detected in the wobble window section is checked in step 1240.

If the rising edge of the signal rwb is not detected, it is determined that the signal rwb contains an error and the second control value is output to select the signal pwb in step 1250. If the rising edge of the signal rwb is detected, it is determined that the signal rwb does not contain an error and the first control value is output to select the signal rwb, in step 1260.

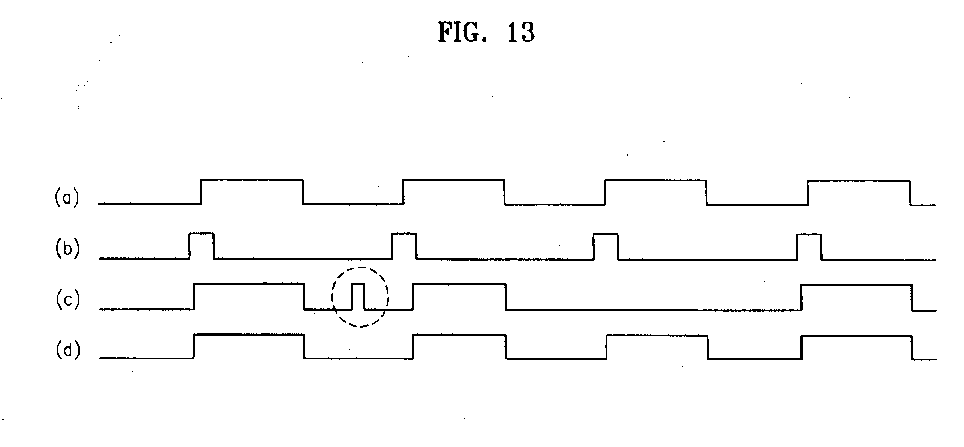

Figure 13 shows timing diagrams of signals for explaining a process of correcting a raw wobble signal rwb according to the present invention. Referring to Figure 13, (a) shows a waveform of the signal rwb that is input to a PLL circuit and stabilized, (b) shows a waveform of a window signal that is generated at rising edges of a phase locked wobble signal pwb, (c) shows a waveform of the signal rwb that is obtained by binarizing a wobble signal read from an optical recording medium, and contains a glitch signal, and (d) shows a waveform of a raw wobble signal rwb that is corrected and output according to an embodiment of the present invention.

In an apparatus and method for detecting and correcting a wobble signal containing an error, according to the present invention, the error in the wobble signal can be effectively corrected, thereby stabilizing an optical recording system and increasing the performance of the system.

According to the present invention, an error in a wobble signal is detected using a window signal and a corrected wobble signal is output, thereby increasing the performance of a recording and reproducing system for an optical recording medium.

Although a few preferred embodiments have been shown and described, it will be appreciated by those skilled in the art that various changes and modifications might be made without departing from the scope of the invention, as defined in the appended claims.

## Claims

1. An apparatus for detecting and correcting an error in a wobble signal, comprising:
a window generator (511) for generating a window signal using a phase locked wobble signal pwb, the signal pwb being generated in synchronization with a raw wobble signal rwb and the signal rwb being obtained by binarizing the wobble signal read from an optical recording medium; and
a control operation unit (512) for correcting an error in the signal rwb and outputting the corrected rwb when the error in the signal rwb is detected in a window.

2. The apparatus of claim 1, wherein the window generator (511) generates a window pulse with a predetermined width at the right and left sides of a rising edge of the signal pwb.

3. The apparatus of claim 2, wherein the window generator (511) comprises:
a right window signal generator (610) generating a window pulse with a predetermined width at the right side of the rising edge of the signal pwb;
a left window signal generator (620) generating a pulse signal of a predetermined width at the left side of the rising edge of the signal pwb; and
a window signal combiner (630) combining the right window pulse and the left window pulse and outputting the combination result.

4. The apparatus of claim 3, wherein the right window signal generator (610) comprises:
a first comparator (611) comparing a first window threshold value with a count value obtained by counting the PLL wobble signal in units of system clocks, outputting level '1' when the count value is smaller than or the same as the first window threshold value, and outputting level '0' otherwise; and
a first AND operation unit (612) performing an AND operation on an output of the first comparator (611) and the pwb and outputting the operation result.

5. The apparatus of claim 3 or 4, wherein the left window signal generator (620) comprises:
a second comparator (621) comparing a second window threshold value with a count value obtained by counting the pwb in units of system clocks, outputting level '1' when the count value is larger than or the same as the second window threshold value, and outputting level '0' otherwise; and
a second AND operation unit (622) performing an AND operation on an output of the second comparator (621) and the PLL wobble signal and outputting the operation unit .

6. The apparatus of claim 4 or 5, wherein the first window threshold value, the second window threshold value, or the count value of a cycle of the signal pwb can be arbitrarily set or changed using a controller.

7. The apparatus of any preceding claim, wherein the control operation unit (512) comprises:
a delay unit (810) delaying the rwb and the pwb for a predetermined time until the error in the raw wobble signal is detected and corrected;
a lock signal generator (820) checking if a PLL operates normally;
a selection signal generator (830) receiving a signal indicating whether the PLL is locked from the lock signal generator (820), checking the presence of arising edge of the raw wobble signal in the window based on the signal, and generating a control value for correcting the error; and
a wobble signal selector (840) selecting one of the input rwb and the pwb in response to the control value output from the selection signal generator (830).

8. The apparatus of claim 7, wherein the control operation unit (512) further comprises a deglitch circuit (800) removing glitch from the rwb and outputting the deglitched rwb to the delay unit, the rwb being obtained by binarizing a wobble signal read from an optical recording medium.

9. The apparatus of claim 7 or 8, wherein the lock signal generator (820) outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

10. The apparatus of claim 7, 8 or 9, wherein:
the selection signal generator (830) outputs a first control value for selecting the rwb when a signal, which indicates the unlocking of the PLL, is output from the lock signal generator (820); and
the selection signal generator (830) checks if a window appears, the selection signal generator (830) outputs a second control value for selecting the pwb out of the window timing, outputs the first control value in the window timing when the rising edge of the raw wobble signal is detected, and outputs the second control value in the window timing when the rising edge of the raw wobble signal is not detected.

11. The apparatus of claim 10, wherein the wobble signal selector (840) outputs the rwb when the first control value is output from the selection signal generator (830), and outputs the pwb when the second control value is output from the selection signal.

12. A phase locked loop (PLL) circuit that generates system clocks using a wobble signal output from an optical recording medium, the PLL circuit comprising:
a wobble signal correcting unit (510) checking whether a raw wobble signal rwb is phase locked, correcting the signal rwb, and inputting the corrected signal rwb to a PLL, the signal rwb being from an optical recording medium and binarized.

13. The PLL circuit of claim 12, wherein the wobble signal correcting unit comprises:
a window generator (511) generating a detection window using a phase locked wobble signal pwb, the signal pwb obtained by phase locking the signal rwb using the PLL; and
a control operation unit (512) correcting and outputting an error in the signal rwb when the error is detected in a window.

14. The PLL circuit of claim 13, wherein the window generator (511) generates a pulse signal of a predetermined width at the right and left sides of a rising edge of the signal pwb.

15. The PLL circuit of claim 13 or 14, wherein the window generator (511) comprises:
a right window signal generator (610) generating a pulse signal of a predetermined width at the right side of the rising edge of the signal pwb;
a left window signal generator (620) generating a pulse signal of a predetermined width at the left side of the rising edge of the signal pwb; and
a window signal combiner (630) combining the right pulse signal and the left pulse signal and outputting the combination result.

16. The PLL circuit of claim 15, wherein the right window signal generator (610) comprises:
a first comparator (611) comparing a first window threshold value with a count value, outputting level '1' when the count value is smaller than or the same as the first window threshold value, and outputting level '0' otherwise, the count value obtained by counting the signal pwb in units of system clocks; and
a first AND operation unit (612) performing an AND operation on an output of the first comparator (611) and the signal pwb and outputting the operation result.

17. The PLL circuit of claim 15 or 16, wherein the left window signal generator (620) comprises:
a second comparator (621) comparing a second window threshold value with a count value, outputting level '1' when the count value is larger than or the same as the second window threshold value, and outputting level '0' otherwise, the count value obtained by counting the signal pwb in units of system clocks; and
a second AND operation unit (622) performing an AND operation on an output of the second comparator (621) and the signal pwb and outputting the operation result.

18. The PLL circuit of claim 16 or 17, wherein the first window threshold value, the second threshold value, or the count value of a cycle of the signal pwb may be arbitrarily set or changed using a controller such as a microcomputer.

19. The PLL circuit of any of claims 13 to 18, wherein the control operation unit (512) comprises:
a delay unit (810) delaying the rwb and pwb for a predetermined time until the error in the signal rwb is detected and corrected;
a lock signal generator (820) checking if the PLL operates normally;
a selection signal generator (830) receiving a signal indicating whether the PLL is locked from the lock signal generator (820), checking the presence of a rising edge of the raw wobble signal in the window based on the signal, and generating a control value for correcting the error; and
a wobble signal selector (840) selecting one of the input rwb and the pwb in response to the control value output from the selection signal generator (830).

20. The PLL circuit of claim 19 or 20, wherein the control operation unit (512) further comprises a deglitch circuit (800) removing glitch from the rwb and outputting the deglitched rwb to the delay unit, the rwb being obtained by binarizing a wobble signal read from an optical recording medium.

21. The PLL circuit of claim 19 or 20, wherein the lock signal generator (820) outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

22. The PLL circuit of claim 19, 20 or 21, wherein:
the selection signal generator (830) outputs a first control value for selecting the rwb when a signal, which indicates the unlocking of the PLL, is output from the lock signal generator (820); and
the selection signal generator (830) checks if a window appears, the selection signal generator (830) outputs a second control value for selecting the pwb out of the window timing, outputs the first control value in the window timing when the rising edge of the raw wobble signal is detected, and outputs the second control value in the window timing when the rising edge of the raw wobble signal is not detected.

23. The PLL circuit of claim 22, wherein the wobble signal selector (840) outputs the signal rwb in response to the first control value generated from the selection signal generator (830), and outputs the signal pwb in response to the second control value generated from the selection signal generator (830).

24. A phase locked loop (PLL) circuit that generates system clocks using a wobble signal output from an optical recording medium, comprising:
a pre-processor (500) reading a wobble signal output from an optical recording medium, binarizing the wobble signal, and outputting the binarized wobble signal as a raw wobble signal rwb;
a wobble error detecting and correcting unit (510) detecting an error in the signal rwb and outputting a phase locked signal pwb instead of the signal rwb when the error in the signal rwb is detected, the signal pwb being in phase with the signal rwb;
a phase comparator (521) comparing the phase of the corrected signal rwb output from the wobble error detecting and correcting unit (510) with that of the signal pwb, and outputting a voltage corresponding to the difference between the corrected rwb and the pwb;
a voltage-controlled oscillator (523) converting a voltage signal output from the phase comparator (521) into a system clock signal of predetermined frequency and outputting the system clock signal; and
a frequency divider (524) dividing the frequency of system clock signal to follow the signal rwb and outputting the result as the signal pwb.

25. The PLL circuit of claim 24, wherein the wobble error detecting and correcting unit (510) comprises:
a window generator (511) generating a window using the signal pwb obtained by phase locking the signal rwb through a PLL; and
a control operation unit (512) correcting the error in the signal rwb and outputting the corrected signal rwb when the error in the signal rwb is detected in a window.

26. The PLL circuit of claim 25, wherein the window generator (511) generates a pulse signal of predetermined width at the right and left sides of the rising edge of the signal pwb.

27. The PLL circuit of claim 25 or 26, wherein the window generator (511) comprises:
a right window signal generator (610) generating a pulse signal of predetermined with at the right side of the rising edge of the signal pwb;
a left window signal generator (620) generating a pulse signal of predetermined width at the left side of the rising edge of the signal pwb; and
a window signal combiner (630) combining the pulse signals at the right and left sides of the rising edge and outputting the combination result.

28. The PLL circuit of claim 27, wherein the right window signal generator (610) comprises:
a first comparator (611) comparing a first window threshold value with a count value, outputting level '1' when the count value is smaller than or the same as the first window threshold value, and outputting level '0' otherwise, the count value obtained by counting the signal pwb in units of system clocks; and
a first AND operation unit (612) performing an AND operation on an output of the first comparator (611) and the signal pwb and outputting the operation result.

29. The PLL circuit of claim 27 or 28, wherein the left window signal generator (620) comprises:
a second comparator (621) comparing a second window threshold value with a count value, outputting level '1' when the count value is larger than or the same as the second window threshold value, and outputting level '0' otherwise, the count value obtained by counting the signal pwb in units of system clocks; and
a second AND operation unit (622) performing an AND operation on an output of the second comparator (621) and the signal pwb and outputting the operation result.

30. The PLL circuit of claim 28 or 29, wherein the first window threshold value, the second window threshold value, or the count value of the cycle of the signal pwb may be arbitrarily set or changed using a controller such as a microcomputer.

31. The PLL circuit of any of claims 25 to 30, wherein the control operation unit (512) comprises:
a delay unit (810) delaying the rwb and the pwb for a predetermined time until the error in the raw wobble signal is detected and corrected;
a lock signal generator (820) checking if a PLL operates normally;
a selection signal generator (830) receiving a signal indicating whether the PLL is locked from the lock signal generator (820), checking the presence of a rising edge of the raw wobble signal in the window based on the signal, and generating a control value for correcting the error; and
a wobble signal selector (840) selecting one of the input rwb and the pwb in response to the control value output from the selection signal generator (830).

32. The PLL circuit of claim 31, wherein the control operation unit (512) further comprises a deglitch circuit (800) removing glitch from the rwb and outputting the deglitched rwb to the delay unit, the rwb being obtained by binarizing a wobble signal read from an optical recording medium.

33. The PLL circuit of claim 31 or 32, wherein the lock signal generator (820) outputs a signal indicating the locking of the PLL when rising edge of the rwb is detected in a window more than predetermined times in a row, and outputs a signal indicating the unlocking of the PLL when the rising edge of the rwb is not detected more than predetermined times in a row.

34. The PLL circuit of claim 31, 32 or 33, wherein the selection signal generator (830) outputs a first control value for selecting the rwb when a signal, which indicates the unlocking of the PLL, is output from the lock signal generator (820), and the selection signal generator (830) checks if a window appears, the selection signal generator (830) outputs a second control value for selecting the pwb out of the window timing, outputs the first control value in the window timing when the rising edge of the raw wobble signal is detected, and outputs the second control value in the window timing when the rising edge of the raw wobble signal is not detected.

35. The PLL circuit of claim 34, wherein the wobble signal selector (840) outputs the signal rwb in response to the first control value output from the selection signal generator (830), and outputs the signal pwb in response to the second control value output from the selection signal generator (830).

36. An optical recording apparatus comprising the apparatus of any of claims 1 to 11.

37. An optical recording apparatus comprising the circuit of any of claims 12 to 35.

## Patentansprüche

1. Vorrichtung zum Erfassen und Korrigieren eines Fehlers in einem Wobbelsignal, enthaltend:
einen Fenstergenerator (511) zum Erzeugen eines Fenstersignals unter Verwendung eines phasenverriegelten Wobbelsignals pwb, wobei das Signal pwb synchron mit einem Wobbel-Rohsignal rwb erzeugt wird und man das Signal rwb **dadurch** erhält, dass das Wobbelsignal, das von einem optischen Aufzeichnungsmedium gelesen wird, binarisiert wird; und
eine Steuervorgangseinheit (512) zum Korrigieren eines Fehlers im Signal rwb und Ausgeben des korrigierten rwb, wenn der Fehler im Signal rwb in einem Fenster erfasst wird.

2. Vorrichtung nach Anspruch 1, bei dem der Fenstergenerator (511) einen Fensterimpuls mit einer vorbestimmten Breite auf der rechten und der linken Seite einer Anstiegsflanke des Signals pwb erzeugt.

3. Vorrichtung nach Anspruch 2, bei der der Fenstergenerator enthält:
einen Generator (610) zum Erzeugen eines rechten Fenstersignals, der einen Fensterimpuls mit einer vorbestimmten Breite auf der rechten Seite der Anstiegsflanke des Signals pwb erzeugt;
einen Generator (620) zum Erzeugen eines linken Fenstersignals, der ein lmpulssignals einer vorbestimmten Breite auf der linken Seite der Anstiegsflanke des Signals pwb erzeugt; und
einen Fenstersignalkombinierer (630), der den rechten Fensterimpuls und den linken Fensterimpuls kombiniert und das Kombinationsergebnis ausgibt.

4. Vorrichtung nach Anspruch 2, bei der der Generator (610) zum Erzeugen eines rechten Fenstersignals enthält:
einen ersten Komparator (611), der einen ersten Fensterschwellenwert mit einem Zählwert vergleicht, den man durch Zählen des PLL-Wobbelsignals in Einheiten von Systemtakten erhält, einen Pegel "1" ausgibt, wenn der Zählwert kleiner oder gleich dem ersten Fensterschwellenwert ist, und im anderen Fall den Pegel "0" ausgibt; und
eine erste UND-Vorgangseinheit (612), die einen UND-Vorgang an einer Ausgabe des ersten Komparators (611) und pwb ausführt und das Vorgangsergebnis ausgibt.

5. Vorrichtung nach Anspruch 3 oder 4, bei der der Generator (620) zum Erzeugen eines linken Fenstersignals enthält:
einen zweiten Komparator (621), der einen zweiten Fensterschwellenwert mit einem Zählwert vergleicht, den man durch Zählen von pwb in Einheiten von Systemtakten erhält, einen Pegel "1" ausgibt, wenn der Zählwert größer gleich dem zweiten Fensterschwellenwert ist, und andernfalls einen Pegel "0" ausgibt; und
eine zweite UND-Vorgangseinheit (622), die einen UND-Vorgang an einer Ausgabe des zweiten Komparators (621) sowie dem PLL-Wobbelsignal ausführt und die Vorgangseinheit ausgibt.

6. Vorrichtung nach Anspruch 4 oder 5, bei der der erste Fensterschwellenwert, der zweite Fensterschwellenwert oder der Zählwert eines Zyklus des Signals pwb willkürlich eingestellt oder unter Verwendung eines Controllers geändert werden können.

7. Vorrichtung nach einem der vorhergehenden Ansprüche, bei der die Steuervorgangseinheit (512) enthält:
eine Verzögerungseinheit (810), die rwb und pwb für eine vorbestimmte Zeit verzögert, bis der Fehler im Wobbel-Rohsignal erfasst und korrigiert ist;
einen Verriegelungssignalgenerator (820), der prüft, ob der PLL normal arbeitet;
einen Wählsignalgenerator (830), der ein Signal, das kennzeichnet, ob der PLL verriegelt ist, vom Verriegelungssignalgenerator (820) empfängt, die Gegenwart einer Anstiegsflanke des Wobbel-Rohsignals im Fenster auf der Basis des Signals prüft und einen Steuerwert zum korrigieren des Fehlers erzeugt; und
eine Wobbelsignal-Wähleinheit (840), die eines der eingegebenen rwp und pwb in Erwiderung des Steuerwertes wählt, der aus dem Wählsignalgenerator (830) ausgegeben wird.

8. Vorrichtung nach Anspruch 7, bei der die Steuervorgangseinheit (512) weiterhin eine Störspitzenbeseitigungsschaltung (800) enthält, die Störspitzen aus rwb entfernt, und das störspitzenbeseitigte rwb an die Verzögerungsschaltung ausgibt, wobei man rwb durch Binarisieren eines Wobbelsignals erhält, das von einem optischen Aufzeichnungsmedium gelesen wird.

9. Vorrichtung nach Anspruch 7 oder 8, bei der der Verriegelungssignalgenerator (820) ein Signal ausgibt, das die Verriegelung des PLL kennzeichnet, wenn die Anstiegsflanke von rwb in einem Fenster öfters als eine vorbestimmte Zahl in einer Reihe erfasst wird, und ein Signal ausgibt, das die Entriegelung des PLL kennzeichnet, wenn die Anstiegsflanke von rwb nicht öfters als eine vorbestimmte Zahl in einer Reihe erfasst wird.

10. Vorrichtung nach Anspruch 7, 8 oder 9, bei der
der Wählsignalgenerator (830) einen ersten Steuerwert zum Wählen von rwb ausgibt, wenn ein Signal, das die Entriegelung der PLL kennzeichnet, aus dem Verriegelungssignalgenerator (820) ausgegeben wird; und
der Wählsignalgenerator (830) prüft, ob ein Fenster erscheint, der Wählsignalgenerator (830) einen zweiten Steuerwert zum Wählen von pwb außerhalb der Fensterzeit ausgibt, den ersten Steuerwert innerhalb der Fensterzeit ausgibt, wenn die Anstiegsflanke des Wobbel-Rohsignals erfasst wird, und den zweiten Steuerwert innerhalb der Fensterzeit ausgibt, wenn die Anstiegsflanke des Wobbel-Rohsignals nicht erfasst wird.

11. Vorrichtung nach Anspruch 10, bei der der Wobbelsignal-Generator (840) rwb ausgibt, wenn der erste Steuerwert vom Wählsignalgenerator (830) ausgegeben wird, und pwb ausgibt, wenn der zweite Steuerwert aus dem Wählsignal ausgegeben wird.

12. Phasenregelkreis (PLL), der Systemtakte unter Verwendung eines Wobbelsignals erzeugt, das von einem optischen Aufzeichnungsmedium ausgegeben wird, wobei der PLL enthält:
eine Wobbelsignal-Korrektureinheit (510), die prüft, ob ein Wobbel-Rohsignal rwb phasenverriegelt ist, das Signal rwb korrigiert und das korrigierte Signal rwb in einen PLL eingibt, wobei das Signal rwb von einem optischen Aufzeichnungsmedium stammt und binarisiert ist.

13. PLL nach Anspruch 12, bei dem die Wobbelsignal-Korrektureinheit enthält:
einen Fenstergenerator (511), der ein Erfassungsfenster unter Verwendung eines phasenverriegelten Wobbelsignals pwb erzeugt, wobei man das Signal pwb durch Phasenverriegelung des Signals rwb mit Hilfe des PLL erhält;
eine Steuervorgangseinheit (512), die einen Fehler im Signal rwb korrigiert und ausgibt, wenn der Fehler in einem Fenster erfasst wird.

14. PLL nach Anspruch 13, bei dem der Fenstergenerator (511) ein Impulssignal einer vorbestimmten Breite auf der rechten und linken Seite einer Anstiegsflanke des Signals pwb erzeugt.

15. PLL nach Anspruch 13 oder 14, bei dem der Fenstergenerator enthält:
einen Generator (610) zum Erzeugen eines rechten Fenstersignals, der ein lmpulssignal einer vorbestimmten Breite auf der rechten Seite der Anstiegsflanke des Signals pwb erzeugt;
einen Generator (620) zum Erzeugen eines linken Fenstersignals, der ein Impulssignal einer vorbestimmten Breite auf der linken Seite der Anstiegsflanke des Signals pwb erzeugt; und
einen Fenstersignalkombinierer (630), der das rechte Impulssignal und das linke lmpulssignal kombiniert und das Kombinationsergebnis ausgibt.

16. PLL nach Anspruch 15, bei der der Generator (610) zum Erzeugen eines rechten Fenstersignals enthält:
einen ersten Komparator (611), der einen ersten Fensterschwellenwert mit einem Zählwert vergleicht, einen Pegel "1" ausgibt, wenn der Zählwert kleiner gleich dem ersten Fensterschwellenwert ist, und andernfalls den Pegel "0" ausgibt, wobei man den Zählwert erhält, indem man das Signal pwb in Einheiten von Systemtakten zählt; und
eine erste UND-Vorgangseinheit (612), die einen UND-Vorgang an einer Ausgabe des ersten Komparators (611) sowie dem Signal pwb ausführt und das Vorgangsergebnis ausgibt.

17. PLL nach Anspruch 15 oder 16, bei dem der Generator (620) zum Erzeugen eines linken Fenstersignals enthält:
einen zweiten Komparator (621), der einen zweiten Fensterschwellenwert mit einem Zählwert vergleicht, den Pegel "1" ausgibt, wenn der Zählwert größer oder gleich dem zweiten Fensterschwellenwert ist, und andernfalls den Pegel "0" ausgibt, wobei man den Zählwert erhält, indem das Signal pwb in Einheiten von Systemtakten gezählt wird; und
eine zweite UND-Vorgangseinheit (622), die einen UND-Vorgang an einer Ausgabe des zweiten Komparators (621) sowie dem Signal pwb ausführt und das Vorgangsergebnis ausgibt.

18. PLL nach Anspruch 16 oder 17, bei dem der erste Fensterschwellenwert, der zweite Fensterschwellenwert oder der Zählwert eines Zyklus des Signals pwb willkürlich eingestellt oder unter Verwendung eines Controllers, wie etwa eines Mikrocomputers geändert werden können.

19. PLL nach einem der Ansprüche 13 bis 18, bei dem die Steuervorgangseinheit (512) enthält:
eine Verzögerungseinheit (810), die rwb und pwb für eine vorbestimmte Zeit verzögert, bis der Fehler im Signal rwb erfasst und korrigiert ist;
einen Verriegelungssignalgenerator (820), der prüft, ob der PLL normal arbeitet;
einen Wählsignalgenerator (830), der ein Signal, das kennzeichnet, ob der PLL verriegelt ist, vom Verriegelungssignalgenerator (820) empfängt, die Gegenwart einer Anstiegsflanke des Wobbel-Rohsignals im Fenster auf der Basis des Signals prüft und einen Steuerwert zum korrigieren des Fehlers erzeugt; und
eine Wobbelsignal-Wähleinheit (840), die eines der eingegebenen rwp und pwb in Erwiderung des Steuerwertes wählt, der aus dem Wählsignalgenerator (830) ausgegeben wird.

20. PLL nach Anspruch 19 oder 20, bei dem die Steuervorgangseinheit (512) weiterhin eine Störspitzenbeseitigungsschaltung (800) enthält, die Störspitzen aus rwb entfernt und das störspitzenbeseitigte rwb an die Verzögerungsschaltung ausgibt, wobei man rwb durch Binarisieren eines Wobbelsignals erhält, das von einem optischen Aufzeichnungsmedium gelesen wird.

21. PLL nach Anspruch 19 oder 20, bei dem der Verriegelungssignalgenerator (820) ein Signal ausgibt, das die Verriegelung des PLL kennzeichnet, wenn die Anstiegsflanke von rwb in einem Fenster öfters als eine vorbestimmte Zahl in einer Reihe erfasst wird, und ein Signal ausgibt, das die Entriegelung des PLL kennzeichnet, wenn die Anstiegsflanke von rwb nicht öfters als eine vorbestimmte Zahl in einer Reihe erfasst wird.

22. PLL nach Anspruch 19, 20 oder 21, bei dem
der Wählsignalgenerator (830) einen ersten Steuerwert zum Wählen von rwb ausgibt, wenn ein Signal, das die Entriegelung des PLL kennzeichnet, aus dem Verriegelungssignalgenerator (820) ausgegeben wird; und
der Wählsignalgenerator (830) prüft, ob ein Fenster erscheint, der Wählsignalgenerator (830) einen zweiten Steuerwert zum Wählen von pwb außerhalb der Fensterzeit ausgibt, den ersten Steuerwert innerhalb der Fensterzeit ausgibt, wenn die Anstiegsflanke des Wobbei-Rohsignals erfasst wird, und den zweiten Steuerwert innerhalb der Fensterzeit ausgibt, wenn die Anstiegsflanke des Wobbel-Rohsignals nicht erfasst wird.

23. PLL nach Anspruch 22, bei der der Wobbelsignal-Generator (840) das Signal rwb in Erwiderung des ersten Steuerwertes, der vom Wählsignalgenerator (830) erzeugt wird, ausgibt und das Signal pwb in Erwiderung des zweiten Steuerwertes ausgibt, der vom Wählsignalgenerator (830) erzeugt wird.

24. Phasenregelkreis (PLL), der Systemtakte unter Verwendung eines Wobbelsignals erzeugt, das von einem optischen Aufzeichnungsmedium ausgegeben wird, enthaltend:
eine Vorverarbeitungseinrichtung (500), die ein Wobbelsignal liest, das von einem optischen Aufzeichnungsmedium ausgegeben wird, das Wobbelsignal binarisiert und das binarisierte Wobbelsignal als Wobbel-Rohsignal rwb ausgibt;
eine Wobbel-Fehlererfassungs- und Korrektureinheit (510), die einen Fehler im Signal rwb erfasst und ein phasenverriegeltes Signal pwb anstelle des Signals rwb ausgibt, wenn der Fehler im Signal rwb erfasst wird, wobei das Signal pwb phasengleich mit dem Signal rwb ist;
einen Phasenkomparator (521), der die Phase der korrigierten Signals rwb, das aus der Wobbel-Fehlererfassungs- und Korrektureinheit (510) ausgegeben wird, mit jener des Signals pwb vergleicht und eine Spannung entsprechend der Differenz zwischen dem korrigierten rwb und pwb ausgibt;
einen spannungsgesteuerten Oszillator (523), der ein Spannungssignal, das aus dem Phasenkomparator (521) ausgegeben wird, in ein Systemtaktsignal einer vorbestimmten Frequenz umwandelt und das Systemtaktsignal ausgibt; und
einen Frequenzteiler (524), der die Frequenz des Systemtaktsignals umwandelt, um dem Signal rwb zu folgen, und das Ergebnis als Signal pwb ausgibt.

25. PLL nach Anspruch 24, bei dem die Wobbel-Fehlererfassungs- und Korrektureinheit (510) enthält:
einen Fenstergenerator (511), der ein Fenster unter Verwendung des Signals pwb erzeugt, das man durch Phasenverriegelung des Signals rwb durch einen PLL erhält; und
eine Steuervorgangseinheit (512), die den Fehler im Signal rwb korrigiert und das korrigierte Signal rwb ausgibt, wenn der Fehler im Signal rwb in einem Fenster erfasst wird.

26. PLL nach Anspruch 25, bei dem der Fenstergenerator (511) ein Impulssignal einer vorbestimmten Breite auf der rechten und der linken Seite der Anstiegsflanke des Signals pwb erzeugt.

27. PLL nach Anspruch 25 oder 26, bei dem der Fenstergenerator (511) enthält:
einen Generator (610) zum Erzeugen eines rechten Fenstersignals, der ein Impulssignal mit einer vorbestimmten Breite auf der rechten Seite der Anstiegsflanke des Signals pwb erzeugt;
einen Generator (620) zum Erzeugen eines linken Fenstersignals, der ein Impulssignal einer vorbestimmten Breite auf der linken Seite der Anstiegsflanke des Signals pwb erzeugt; und
einen Fenstersignalkombinierer (630), der die Impulssignale auf der rechten und der linken Seite der Anstiegsflanke kombiniert und das Kombinationsergebnis ausgibt.

28. PLL nach Anspruch 27, bei dem der Generator (610) zum Erzeugen eines rechten Fenstersignals enthält:
einen ersten Komparator (611), der einen ersten Fensterschwellenwert mit einem Zählwert vergleicht, einen Pegel "1" ausgibt, wenn der Zählwert kleiner oder gleich dem ersten Fensterschwellenwert ist, und im anderen Fall den Pegel "0" ausgibt; wobei man den Zählwert erhält, indem man das Signal pwb in Einheiten von Systemtakten zählt; und
eine erste UND-Vorgangseinheit (612), die einen UND-Vorgang an einer Ausgabe des ersten Komparators (611) und dem Signal pwb ausführt und das Vorgangsergebnis ausgibt.

29. PLL nach Anspruch 27 oder 28, bei dem der Generator (620) zum Erzeugen eines linken Fenstersignals enthält:
einen zweiten Komparator (621), der einen zweiten Fensterschwellenwert mit einem Zählwert vergleicht, einen Pegel "1" ausgibt, wenn der Zählwert größer gleich dem zweiten Fensterschwellenwert ist, und andernfalls einen Pegel "0" ausgibt, wobei man den Zählwert durch Zählen des Signals pwb in Einheiten von Systemtakten erhält; und
eine zweite UND-Vorgangseinheit (622), die einen UND-Vorgang an einer Ausgabe des zweiten Komparators (621) sowie dem Signal pwb ausführt und das Vorgangsergebnis ausgibt.

30. PLL nach Anspruch 28 oder 29, bei dem der erste Fensterschwellenwert, der zweite Fensterschwellenwert oder der Zählwert eines Zyklus des Signals pwb willkürlich eingestellt oder unter Verwendung eines Controllers, wie etwa eines Mikrocomputers geändert werden können.

31. PLL nach einem der vorhergehenden Ansprüche 25 bis 39, bei dem die Steuervorgangseinheit (512) enthält:
eine Verzögerungseinheit (810), die rwb und pwb für eine vorbestimmte Zeit verzögert, bis der Fehler im Wobbel-Rohsignal erfasst und korrigiert ist;
einen Verriegelungssignalgenerator (820), der prüft, ob der PLL normal arbeitet;
einen Wählsignalgenerator (830), der ein Signal, das kennzeichnet, ob der PLL verriegelt ist, vom Verriegelungssignalgenerator (820) empfängt, die Gegenwart einer Anstiegsflanke des Wobbel-Rohsignals im Fenster auf der Basis des Signals prüft und einen Steuerwert zum Korrigieren des Fehlers erzeugt; und
eine Wobbelsignal-Wähleinheit (840), die eines der eingegebenen rwp und pwb in Erwiderung des Steuerwertes wählt, der aus dem Wählsignalgenerator (830) ausgegeben wird.

32. PLL nach Anspruch 31, bei dem die Steuervorgangseinheit (512) weiterhin eine Störspitzenbeseitigungsschaltung (800) enthält, die Störspitzen aus rwb entfernt, und das störspitzenbeseitigte rwb an die Verzögerungsschaltung ausgibt, wobei man rwb durch Binarisieren eines Wobbelsignals erhält, das von einem optischen Aufzeichnungsmedium gelesen wird.

33. PLL nach Anspruch 31 oder 32, bei dem der Verriegelungssignalgenerator (820) ein Signal ausgibt, das die Verriegelung des PLL kennzeichnet, wenn die Anstiegsflanke des rwb in einem Fenster öfters als eine vorbestimmte Zahl in einer Reihe erfasst wird, und ein Signal ausgibt, das die Entriegelung des PLL kennzeichnet, wenn die Anstiegsflanke des rwb nicht öfters als eine vorbestimmte Zahl in einer Reihe erfasst wird.

34. PLL nach Anspruch 31, 32 oder 33, bei dem der Wählsignalgenerator (830) einen ersten Steuerwert zum Wählen des rwb ausgibt, wenn ein Signal, das die Entriegelung des PLL kennzeichnet, aus dem Verriegelungssignalgenerator (820) ausgegeben wird, und der Wählsignalgenerator (830) prüft, ob ein Fenster erscheint, der Wählsignalgenerator (830) einen zweiten Steuerwert zum Wählen des pwb außerhalb der Fensterzeit ausgibt, den ersten Steuerwert innerhalb der Fensterzeit ausgibt, wenn die Anstiegsflanke des Wobbel-Rohsignals erfasst wird, und den zweiten Steuerwert innerhalb der Fensterzeit ausgibt, wenn die Anstiegsflanke des Wobbel-Rohsignals nicht erfasst wird.

35. PLL nach Anspruch 34, bei dem der Wobbelsignal-Generator (840) das Signal rwb in Erwiderung des ersten Steuerwertes ausgibt, der vom Wählsignalgenerator (830) ausgegeben wird, und das pwb in Abhängigkeit des zweiten Steuerwertes ausgibt, der aus dem Wählsignalgenerator (830) ausgegeben wird.

36. Optische Aufzeichnungsvorrichtung, enthaltend die Vorrichtung nach einem der Ansprüche 1 bis 11.

37. Optische Aufzeichnungsvorrichtung, enthaltend die Schaltung nach einem der Ansprüche 12 bis 35.

## Revendications

1. Dispositif de détection et de correction d'une erreur dans un signal de wobulation, comprenant :
un générateur de créneau (511) permettant de générer un signal de créneau utilisant un signal de wobulation de phase verrouillée pwb, le signal pwb étant généré en synchronisation avec un signal de wobulation brut rwb et le signal étant obtenu en binarisant le signal de wobulation lu sur un support d'enregistrement optique ; et
une unité de fonction de commande (512) pour la correction de l'erreur dans le signal rwb qui restitue le signal rwb corrigé lorsque l'erreur dans le signal est détectée dans un créneau.

2. Dispositif selon la revendication 1, dans lequel le générateur de créneau (511) génère une pulsation de créneau d'une largeur prédéterminée sur les côtés droit et gauche d'une arête montante du signal pwb.

3. Dispositif selon la revendication 2, dans lequel le générateur de créneau (511) comprend :
un générateur de signal de créneau droit (610) générant un pulsation de créneau de largeur prédéterminée du côté droit de l'arête montante du signal pwb ;
un générateur de signal de créneau gauche (620) générant un pulsation de créneau de largeur prédéterminée du côté gauche de l'arête montante du signal pwb ; et
un combinateur de signal de créneau (630) associant la pulsation de créneau droite et la pulsation de créneau gauche et restituant le résultat de cette combinaison.

4. Dispositif selon la revendication 3, dans lequel le générateur de signal de créneau droit (610) comprend :
un premier comparateur (611) confrontant le seuil du premier créneau avec une valeur de compteur obtenue en comptant le signal de wobulation dans les unités des horloges système, restituant un niveau '1' lorsque la valeur du compteur est inférieure ou égale à la valeur seuil du premier créneau et restituant un niveau 'o' lorsque la valeur du compteur est supérieure ; et,
une première unité d'opération logique 'ET' (612) effectuant une opération logique 'ET' sur une sortie du premier comparateur (611) et sur le signal pwb et restituant le résultat de l'opération.

5. Dispositif selon la revendication 3 ou 4, dans lequel le générateur de signal de créneau gauche (620) comprend :
un deuxième comparateur (621) comparant la seconde valeur seuil du créneau avec une valeur de compteur obtenue en comptant le pwb dans les unités des horloges système, restituant le niveau `1' lorsque la valeur de compteur est supérieure ou égale à la deuxième valeur seuil de créneau, et restituant le niveau '0' lorsque la valeur de compteur est inférieure à la deuxième valeur seuil de créneau ; et
une seconde unité d'opération logique 'ET' (622) effectuant une opération logique 'ET' sur la sortie du second comparateur (621) et sur le signal de wobulation du PLL et restitue le résultat de l'opération logique.

6. Dispositif selon la revendication 4 ou 5, dans lequel la première valeur seuil de créneau, la seconde valeur seuil de créneau et la valeur de compteur d'un cycle du signal pwb peuvent être arbitrairement réglées ou modifiées à l'aide d'un contrôleur.

7. Dispositif selon l'une quelconque des revendications précédentes, dans lequel l'unité de fonction de commande (512) comprend :
une unité de retardement (810) retardant les signaux rwb et pwb d'une durée prédéterminée jusqu'à ce que l'erreur dans le signal de wobulation brut soit détectée et corrigée ;
un générateur de signal de verrouillage (820) vérifiant si le circuit PLL fonctionne normalement ;
un générateur de signal de sélection (830) recevant un signal indiquant si le PLL est verrouillé à partir du générateur de signal de verrouillage (820), vérifiant la présence d'une arête montante du signal de wobulation brut dans le créneau basé sur le signal, et générant une valeur de contrôle pour la correction de l'erreur ; et
un sélecteur de signal de wobulation (840) sélectionnant l'une des sorties rwb et le pwb en réponse à la sortie de la valeur de contrôle du générateur de signal de sélection (830).

8. Dispositif selon la revendication 7, dans lequel l'unité de fonction de commande (512) comprend un circuit de suppression de la rayure (800) permettant de supprimer la rayure du signal rwb et restituant le signal rwb sans rayure à l'unité de retardement, le rwb étant obtenu en binarisant un signal de wobulation lu sur un support d'enregistrement optique.

9. Dispositif selon la revendication 7 ou 8, dans lequel le générateur de signal de verrouillage (820) restitue un signal indiquant le verrouillage du PLL lorsque l'arête montante du rwb est détectée dans un créneau plus de fois que le nombre prédéterminé sur une rangée, et restitue un signal indiquant le déverrouillage du PLL lorsque l'arête montante du rwb n'est pas détectée dans un créneau plus de fois que le nombre prédéterminé sur une rangée.

10. Dispositif selon les revendications 7, 8 ou 9, dans lequel :
le générateur de signal de sélection (830) restitue une première valeur de commande pour la sélection du rwb lorsqu'un signal, lequel indique le déverrouillage du PLL, est restitué par le générateur de signal de déverrouillage (820); et,
le générateur du signal de sélection (830) vérifie si un créneau apparaît, le générateur de signal de sélection (830) restitue une seconde valeur de commande pour la sélection du pwb en dehors du créneau de retardement, il restitue la première valeur de commande dans le créneau lorsque l'arête montante du signal de wobulation brut est détectée, et restitue la seconde valeur de commande dans le créneau lorsque l'arête montante du signal de wobulation brut n'est pas détectée.

11. Dispositif selon la revendication 10, dans lequel le sélecteur de signal de wobulation (840) restitue le rwb lorsque la première valeur de commande est restituée à partir du générateur de signal de sélection (830), et restitue le pwb lorsque la seconde valeur de commande est restituée à partir du signal de sélection.

12. Circuit de verrouillage de phase (PLL) qui génère des horloges système utilisant une sortie de signal de wobulation d'un support d'enregistrement optique. Le circuit PLL comprenant :
une unité de correction du signal de wobulation (510) vérifiant si le signal de wobulation brut rwb est en verrouillage de phase, corrigeant le signal rwb et restituant le signal rwb corrigé à un PLL, le signal rwb provenant d'un support d'enregistrement optique est binarisé.

13. Circuit de verrouillage de phase (PLL) selon la revendication 12 dans lequel l'unité de correction du signal de wobulation comprend :
un générateur de créneau (511) générant un créneau de détection utilisant un signal de wobulation pwb de phase verrouillée, le signal pwb obtenu par verrouillage de phase du signal rwb à l'aide du PLL ; et
une unité de fonction de commande (512) corrigeant et restituant une erreur dans le signal rwb lorsque l'erreur est détectée dans le créneau.

14. Circuit de verrouillage de phase (PLL) selon la revendication 13, dans lequel le générateur de créneau (511) génère un signal de pulsation avec une largeur prédéterminée sur les côtés droit et gauche de l'arête montante du signal pwb.

15. Circuit de verrouillage de phase (PLL) selon la revendication 13 ou 14 dans lequel le générateur de créneau (511) comprend :
un générateur de signal de créneau droit (610) créant une pulsation de créneau ayant une largeur prédéterminée côté droit de l'arête montante du signal pwb ;
un générateur de signal de créneau gauche (620) créant une pulsation de créneau ayant une largeur prédéterminée côté gauche de l'arête montante du signal pwb ; et
un combinateur de signal de créneau (630) associant les pulsations du créneau gauche et du créneau droit et restituant un résultat des données combinées.

16. Circuit PLL selon la revendication 15, dans lequel le générateur de signal de créneau droit (610) comprend :
un premier comparateur (611) confrontant le seuil du premier créneau avec une valeur de compteur obtenue en comptant le signal de wobulation dans les unités d'une horloge système, restituant un niveau '1' lorsque la valeur de compteur est inférieure ou égale à la valeur seuil du premier créneau et restituant un niveau 'o' lorsque la valeur du compteur est supérieure ; et
une première opération logique 'ET' (612) effectuant une opération logique 'ET' sur la sortie du premier comparateur (611) et sur le pwb et restituant le résultat de l'opération.

17. Circuit PLL selon la revendication 15 ou 16, dans lequel le générateur de signal de créneau gauche (620) comprend :
un second comparateur (621) confrontant la valeur seuil d'un second créneau avec une valeur de compteur, obtenue en comptant le pwb dans les unités d'horloges système, et restituant un niveau '1' lorsque la valeur du compteur est supérieure ou égale à la valeur seuil du second créneau et restituant un niveau 'o' lorsque la valeur du compteur est inférieure ; et
une seconde opération logique 'ET' (622) effectuant une opération logique 'ET' sur la sortie du second comparateur (621) et sur le signal de wobulation du PLL et restituant le résultat de l'opération.

18. Circuit PLL selon la revendication 16 ou 17, dans lequel la valeur seuil du premier créneau, la valeur seuil du second créneau et la valeur du compteur d'un cycle du signal pwb puissent être arbitrairement réglées ou modifiées à l'aide d'un contrôleur comme par exemple un micro-ordinateur.

19. Circuit PLL selon l'une quelconque des revendications 13 à 18, dans lequel l'unité de fonction de contrôle (512) comprend :
une unité de retardement (810) permettant de retarder rwb et pwb sur un temps prédéterminé jusqu'à ce que l'erreur présente sur le signal de wobulation brut soit détectée et corrigée ;
un générateur de signal de verrouillage (820) vérifiant si le PLL fonctionne normalement ;
un générateur de signal de sélection (830) recevant un signal indiquant si le PLL est verrouillé à partir du générateur de signal de verrouillage (820), vérifiant la présence d'une arête montante du signal de wobulation brut dans le créneau basé sur le signal, et générant une valeur de contrôle pour la correction de l'erreur ;
enfin, un sélecteur de signal de wobulation (840) sélectionnant l'une des sorties rwb et le pwb en réponse à la sortie de la valeur de contrôle du générateur de signal de sélection (830).

20. Circuit PLL selon la revendication 19 ou 20, dans lequel l'unité de fonction de contrôle (512) comprend en plus un circuit permettant de résorber la rayure (800) du rwb et restituant le rwb sans rayure à l'unité de retardement, le rwb étant obtenu par binarisation du signal de wobulation lu à partir du support d'enregistrement optique.

21. Circuit PLL selon la revendication 19 ou 20, dans lequel le générateur de signal de verrouillage (820) restitue un signal indiquant le verrouillage du PLL lorsque l'arête montante du rwb est détectée dans un créneau plus de fois que le nombre prédéterminé sur une rangée, et restitue un signal indiquant le déverrouillage du PLL lorsque l'arête montante du rwb n'est pas détectée dans un créneau plus de fois que le nombre prédéterminé sur une rangée.

22. Circuit PLL selon les revendications 19, 20, ou 21 dans lequel :
le générateur de signal de sélection (830) restitue une première valeur de contrôle pour la sélection du rwb lorsqu'un signal, lequel indique le déverrouillage du PLL, est restitué par le générateur de signal de déverrouillage (820) ; et,
le générateur du signal de sélection (830) vérifie si un créneau apparaît, le générateur de signal de sélection (830) restitue une seconde valeur de contrôle pour la sélection du pwb en dehors du créneau de retardement lorsque l'arête montante du signal de wobulation brut est détectée, et restitue la seconde valeur de contrôle dans le créneau de retardement lorsque l'arête montante du signal de wobulation brut n'est pas détectée.

23. Circuit PLL selon la revendication 22, dans lequel le sélecteur de signal de wobulation (840) restitue le rwb en réponse à la première valeur de commande restituée par le générateur de signal de sélection (830), et restitue le signal pwb en réponse à la seconde valeur de commande générée par le générateur de signal de sélection (830).

24. Circuit de verrouillage de phase (PLL) qui génère des horloges système en utilisant une sortie de signal de wobulation d'un support d'enregistrement optique, comprenant :
un préprocesseur (500) mesurant un sortie de signal de wobulation d'un support d'enregistrement optique, binarisant le signal de wobulation et restituant le signal de wobulation binarisé sous la forme d'un signal de wobulation brut rwb ;
une unité de détection et de correction de l'erreur de wobulation (510) détectant une erreur dans le signal rwb et restituant un signal de phase verrouillé pwb au lieu de la sortie du signal rwb lorsque l'erreur dans le signal rwb est détectée, le signal pwb étant en phase avec le signal rwb ;
un comparateur de phase (521) comparant la phase de la sortie du signal corrigé rwb de l'unité de correction et de détection de l'erreur de wobulation (510) avec celle du signal pwb, et restituant une tension correspondant à la différence entre le rwb corrigé et le pwb ;
un oscillateur à tension contrôlée (523) convertissant la sortie du signal de tension du comparateur de phase (521) en un signal d'horloge système de fréquence prédéterminée et restituant le signal de l'horloge système ; et
enfin, un diviseur de fréquence (524) divisant la fréquence du signal de l'horloge système pour suivre le signal rwb et restituant le résultat sous la forme d'un signal pwb.

25. Circuit PLL selon la revendication 24, dans lequel l'unité de correction du signal de wobulation (510) comprend :
un générateur de créneau (511) générant un créneau de détection utilisant un signal de wobulation pwb de phase verrouillée, le signal pwb obtenu par verrouillage de phase du signal rwb à travers le PLL ; et,
une unité de fonction de commande (512) corrigeant une erreur dans le signal rwb et restituant le signal rwb corrigé lorsque l'erreur dans le signal rwb est détectée dans un créneau.

26. Circuit PLL selon la revendication 25, dans lequel le générateur de créneau (511) génère un signal de pulsation avec une largeur prédéterminée sur les côtés droit et gauche de l'arête montante du signal pwb.

27. Circuit PLL selon la revendication 25 ou 26, dans lequel le générateur de créneau (511) comprend :
un générateur de signal de créneau droit (610) créant une pulsation de créneau ayant une largeur prédéterminée côté droit de l'arête montante du signal pwb ;
un générateur de signal de créneau gauche (620) créant une pulsation de créneau ayant une largeur prédéterminée côté gauche de l'arête montante du signal pwb ; et,
un combinateur de signal de créneau (630) associant les pulsations du créneau gauche et du créneau droit qui restitue un résultat des données combinées.

28. Circuit PLL selon la revendication 27, dans lequel le générateur de signal de créneau droit (610) comprend :
un premier comparateur (611) confrontant le seuil du premier créneau avec une valeur de compteur obtenue en comptant le signal de wobulation dans les unités d'une horloge système, restituant un niveau '1' lorsque la valeur du compteur est inférieure ou égale à la valeur seuil du premier créneau et restituant un niveau 'o' lorsque la valeur du compteur est supérieure ; et,
un première opération logique 'ET' (612) effectuant une opération logique 'ET' sur la sortie du premier comparateur (611) et sur le pwb et restituant le résultat de l'opération.

29. Circuit PLL selon la revendication 27 ou 28, dans lequel le générateur de signal de créneau gauche (620) comprend :
un second comparateur (621) confrontant la valeur seuil d'un second créneau avec une valeur de compteur obtenue en comptant le pwb dans les unités d'horloges système, restituant un niveau '1' lorsque la valeur du compteur est supérieure ou égale à la valeur seuil du second créneau et restituant un niveau 'o' lorsque la valeur du compteur est inférieure ; et
un second opérateur logique 'ET' (622) effectuant une opération logique 'ET' sur la sortie du second comparateur (621) et sur le signal de wobulation du PLL et restituant le résultat de l'opération.

30. Circuit PLL selon la revendication 28 ou 29 dans lequel la valeur seuil du premier créneau, la valeur seuil du second créneau et la valeur du compteur d'un cycle du signal pwb peuvent être arbitrairement réglées ou modifiées à l'aide d'un contrôleur comme par exemple un micro-ordinateur.

31. Circuit PLL selon l'une quelconque des revendications 25 à 30 dans lequel l'unité de fonction de commande (512) comprend :
une unité de retardement (810) permettant de retarder rwb et pwb sur un temps prédéterminé jusqu'à ce que l'erreur présente sur le signal de wobulation brut soit détectée et corrigée ;
un générateur de signal de verrouillage (820) vérifiant si le PLL fonctionne normalement ;
un générateur de signal de sélection (830) recevant un signal indiquant si le PLL est verrouillé à partir du générateur de signal de verrouillage (820), vérifiant la présence d'une arête montante du signal de wobulation brut dans le créneau basé sur le signal, et générant une valeur de commande pour la correction de l'erreur ;
enfin, un sélecteur de signal de wobulation (840) sélectionnant l'une des sorties rwb et le pwb en réponse à la sortie de la valeur de commande du générateur de signal de sélection (830).

32. Circuit PLL selon la revendication 31 dans lequel l'unité de fonction de commande (512) comprend en plus un circuit permettant de supprimer la rayure (800) du rwb et restituant le rwb sans rayure à l'unité de retardement, le rwb étant obtenu par binarisation du signal de wobulation lu à partir du support d'enregistrement optique.

33. Circuit PLL selon la revendication 31 ou 32 dans lequel le générateur de signal de verrouillage (820) restitue un signal indiquant le verrouillage du PLL lorsque l'arête montante du rwb est détectée dans un créneau plus de fois que le nombre prédéterminé sur une rangée, et qu'il restitue un signal indiquant le déverrouillage du PLL lorsque l'arête montante du rwb n'est pas détectée dans un créneau plus de fois que le nombre prédéterminé sur une rangée.

34. Circuit PLL selon les revendications 31, 32 ou 33 dans lequel le générateur de signal de sélection (830) restitue une première valeur de commande pour la sélection du rwb lorsqu'un signal, lequel indique le déverrouillage du PLL, est restitué par le générateur de signal de déverrouillage (820), et que le générateur du signal de sélection (830) vérifie si un créneau apparaît, le générateur de signal de sélection (830) restitue une seconde valeur de commande pour la sélection du pwb en dehors du créneau de retardement lorsque l'arête montante du signal de wobulation brut est détectée, et restitue la seconde valeur de commande dans le créneau de retardement lorsque l'arête montante du signal de wobulation brut n'est pas détectée.

35. Circuit PLL selon la revendication 34 dans lequel le sélecteur de signal de wobulation (840) restitue le rwb lorsque la première valeur de contrôle est restituée par le générateur de signal de sélection (830) et restitue le pwb en réponse à la seconde valeur de contrôle restituée par le générateur du signal de sélection (830).

36. Dispositif d'enregistrement optique comprenant le dispositif selon l'une quelconque des revendications 1 à 11.

37. Dispositif d'enregistrement optique comprenant le circuit selon l'une quelconque des revendications 12 à 35.
